# EUROPÄISCHE PATENTSCHRIFT

(11) **EP 3 740 042 B1**
(45) Veröffentlichungstag und Bekanntmachung des Hinweises auf die Patenterteilung: **06.10.2021**
(21) Anmeldenummer: 20173037.1
(22) Anmeldetag: 05.05.2020
(51) Int. Cl.: H05B 45/56, F21V 29/54, H01L 23/38, H01L 33/64, H01L 35/00

(54) **ANORDNUNG UND VERFAHREN ZUM BETRIEB EINES HALBLEITERBAUELEMENTS SOWIE LEUCHTE**
ASSEMBLY AND METHOD FOR OPERATING A SEMICONDUCTOR ELEMENT AND LIGHT
AGENCEMENT ET PROCÉDÉ DE FONCTIONNEMENT D'UN COMPOSANT SEMI-CONDUCTEUR AINSI QUE LUMINAIRE

(30) Priorität: 15.05.2019 DE 102019112764
(43) Veröffentlichungstag der Anmeldung: 18.11.2020
(73) Patentinhaber: Marelli Automotive Lighting Reutlingen (Germany) GmbH, 72762 Reutlingen (DE)
(72) Erfinder: Rauskolb, Dietmar, 72762 Reutlingen (DE); Harder, Anna, 72768 Reutlingen (DE)
(74) Vertreter: Kohler Schmid Möbus Patentanwälte

(56) Entgegenhaltungen:
- EP-A2- 2 077 697
- DE-A1-102010 012 078
- DE-A1-102012 208 745
- KR-A- 20100 048 320
- US-A1- 2010 134 024

## Beschreibung

Die Erfindung betrifft eine Anordnung zum Betrieb wenigstens eines Halbleiterbauelements, umfassend wenigstens ein zu betreibendes Halbleiterbauelement und wenigstens eine thermoelektrische Komponente, wobei die thermoelektrische Komponente eingerichtet ist, das Halbleiterbauelement zu temperieren, insbesondere zu kühlen und/oder zu beheizen, wobei die Anordnung wenigstens einen Versorgungsstromanschluss zur Energieversorgung des Halbleiterbauelements mit einem Versorgungsstrom aufweist.

Aus der Offenlegungsschrift DE 43 04 654 A1 ist eine gattungsgemäße Anordnung bekannt. Eine als Peltier-Element ausgebildete thermoelektrische Komponente ist in ein Bauelementesubstrat, insbesondere eine Leiterplatte, integriert. Die thermoelektrische Komponente dient zur Temperierung eines ebenfalls auf dem Bauelementesubstrat angeordneten Bauelements, insbesondere eines Halbleiterbauelements. Die thermoelektrische Komponente ist an eine Gleichspannungs- oder Gleichstromquelle angeschlossen. Der durch die thermoelektrische Komponente durchfließende Strom kann abhängig von der Temperatur des Bauelements gesteuert und/oder geregelt werden. Trotz einer solchen aktiven Temperierung, insbesondere Kühlung, kann es beim Betrieb von Halbleiterbauelementen, beispielsweise Halbleiterlichtquellen wie LEDs, zu hohen thermischen Belastungen der Halbleiterbauelemente kommen. Durch diese hohen thermischen Belastungen können sich unter anderem die Lebensdauern der Halbleiterbauelemente verkürzen. Um daher derartige, hohe thermische Belastungen zu vermeiden, ist teilweise vorgesehen, beispielsweise bei Überschreiten einer maximal zulässigen Betriebstemperatur, das jeweilige oder die jeweiligen Halbleiterbauelemente abzuregeln, um dessen bzw. deren jeweilige Verlustleistungen und damit die Abwärmeproduktion kurzfristig zu reduzieren. Diese Abregelung erfordert jedoch einen zusätzlichen schaltungstechnischen Aufwand. Werden beispielsweise die Halbleiterbauelemente von einer externen Versorgungsstromquelle zur Energieversorgung mit einem Versorgungsstrom versorgt, so sind Vorrichtungen in der externen Versorgungsstromquelle erforderlich, mit denen eine oder mehrere Temperaturen der jeweiligen Halbleiterbauelemente erfasst werden. Ferner sind in der Regel zusätzliche Stromregelelemente erforderlich, mit denen der erzeugte Versorgungsstrom temperaturabhängig geregelt, insbesondere abgeregelt, werden kann. Die Offenlegungsschrift DE 10 2010 012 078 A1 offenbart eine nach dem Oberbegriff des Patentanspruchs 1 Anordnung zum Betrieb wenigstens eines Halbleiterbauelements.

Aufgabe der Erfindung ist es daher, eine gattungsgemäße Anordnung sowie ein Verfahren anzubieten, die eine schaltungstechnisch einfache und dennoch effiziente Temperierung des wenigstens einen Halbleiterbauelements der Anordnung erlauben. Des Weiteren soll eine eine Halbleiterlichtquelle aufweisende Leuchte mit entsprechend verbesserter Temperierung der Halbleiterlichtquelle angeboten werden.

Gelöst wird die Aufgabe durch eine Anordnung zum Betrieb wenigstens eines Halbleiterbauelements, umfassend wenigstens ein zu betreibendes Halbleiterbauelement und wenigstens eine thermoelektrische Komponente, wobei die thermoelektrische Komponente eingerichtet ist, das Halbleiterbauelement zu temperieren, insbesondere zu kühlen und/oder zu beheizen, wobei die Anordnung wenigstens einen Versorgungsstromanschluss zur Energieversorgung des Halbleiterbauelements mit einem Versorgungsstrom aufweist, wobei die Anordnung eine Steuereinheit und einen mit der Steuereinheit verbundenen Temperatursensor, der zur Erfassung einer Temperatur des Halbleiterbauelements eingerichtet ist, aufweist, und wobei die Steuereinheit eingerichtet ist, einen von der Temperatur abhängigen Anteil des am Versorgungsstromanschluss in die Anordnung eingespeisten Versorgungsstroms am Halbleiterbauelement vorbei zu leiten und in die thermoelektrische Komponente zu speisen.

Somit kann der zur Energieversorgung des Halbleiterbauelements eingespeiste Versorgungsstrom verwendet werden, um sowohl das Halbleiterbauelement als auch die thermoelektrische Komponente zu speisen. Das Halbleiterbauelement wird somit abhängig von seiner Temperatur durch einen mindestens um den temperaturabhängigen Anteil verringerten, zweiten Anteil des eingespeisten Versorgungsstroms mit Energie versorgt. Das Halbleiterbauelement kann somit, insbesondere temperaturabhängig, abgeregelt werden. Dadurch kann seine Abwärmeproduktion reduziert werden.

Es kann vorgesehen sein, dass der temperaturabhängige Anteil des Versorgungsstroms, mit dem die thermoelektrische Komponente gespeist wird, mit steigender Temperatur des Halbleiterbauelements ansteigt. Zur Erfassung der Temperatur des Halbleiterbauelements weist die Anordnung einen mit der Steuereinheit verbundenen Temperatursensor auf. Dazu kann die Anordnung den Temperatursensor als separates Bauteil umfassen. Denkbar ist auch, dass der Temperatursensor Teil eines anderen Bauteils der Anordnung ist. Insbesondere kann der Temperatursensor in das Halbleiterbauelement, in die thermoelektrische Komponente und/oder in die Steuereinheit integriert sein. Der Temperatursensor kann als elektronisch wirkendes Bauteil, beispielsweise als Heißleiter, und/oder als mechanisch wirkendes Bauteil, beispielsweise als Bimetallstreifen, ausgebildet sein.

Die Steuereinheit kann eingerichtet sein, den temperaturabhängigen Anteil mittels einer Temperaturinformation des Temperatursensors einzustellen.

Wird der eingespeiste Versorgungsstrom durch eine externe Versorgungsstromquelle erzeugt, so kann die Erzeugung des Versorgungsstroms durch die Versorgungsstromquelle unabhängig von der Temperatur des Halbleiterbauelements erfolgen. Informationen über die Temperatur des Halbleiterbauelements müssen nicht an die externe Versorgungsstromquelle übermittelt werden. In der externen Versorgungsstromquelle kann auf Stromregler oder dergleichen zur temperaturabhängigen Regelung des von ihr erzeugten Versorgungsstroms verzichtet werden. Somit lässt sich die schaltungstechnische Komplexität der Gesamtanordnung ― umfassend die Versorgungsstromquelle und die Anordnung ― wesentlich reduzieren.

Auch kann temperaturabhängig, beispielsweise sobald das Halbleiterbauelement eine Temperaturschwelle erreicht und/oder überschreitet, der temperaturabhängige Anteil des eingespeisten Versorgungsstroms ganz oder teilweise zur, insbesondere alleinigen oder zusätzlichen, Energieversorgung der thermoelektrischen Komponente genutzt werden. Soll das Halbleiterbauelement beispielsweise gekühlt werden, so kann damit die Kühlleistung der thermoelektrischen Komponente gesteigert werden. Somit lässt sich allgemein parallel zur Abregelung des Halbleiterbauelements die Temperierleistung der thermoelektrischen Komponente steigern und somit das Halbleiterbauelement besonders effizient temperieren, insbesondere kühlen.

Die Steuereinheit kann als steuerbare, insbesondere temperaturabhängig steuerbare, Stromquelle ausgebildet sein oder eine solche umfassen. Vorzugsweise kann die als Stromquelle ausgebildete Steuereinheit in Reihe mit der thermoelektrischen Komponente geschaltet sein.

Ist oder umfasst die thermoelektrische Komponente ein Peltier-Element, so kann die Temperierung ohne mechanische, bewegliche Elemente erfolgen. Die thermoelektrische Komponente kann dann zudem wahlweise zum Kühlen oder zum Heizen verwendet werden.

Die Anordnung lässt sich besonders kompakt gestalten, wenn sie ein Bauelementesubstrat, insbesondere eine Leiterplatte, umfasst, wobei die thermoelektrische Komponente in das Bauelementesubstrat integriert ist.

Ein besonders guter Wärmeaustausch zwischen der thermoelektrischen Komponente und dem Halbleiterbauelement lässt sich erreichen, wenn die thermoelektrische Komponente mit dem Halbleiterbauelement thermisch, vorzugsweise unmittelbar, gekoppelt ist. Dazu kann das Halbleiterbauelement, vorzugsweise unmittelbar, in und/oder an der thermoelektrischen Komponente angeordnet sein.

Die Steuereinheit kann durch eine separate Energieversorgung mit Energie versorgt werden. Alternativ kann die Anordnung eingerichtet sein, die Steuereinheit durch einen weiteren Anteil des eingespeisten Versorgungsstroms mit Energie zu versorgen, sodass auf eine zusätzliche, separate Energieversorgung für die Steuereinheit verzichtet werden kann.

Die eingangs genannten hohen Temperaturbelastungen können sich insbesondere beim Betrieb einer oder mehrerer Halbleiterlichtquellen ergeben. Die erfindungsgemäßen Vorteile kommen daher insbesondere dann zum Tragen, wenn das Halbleiterbauelement eine Halbleiterlichtquelle, insbesondere eine LED, ist oder eine solche umfasst.

In den Rahmen der Erfindung fällt insbesondere auch eine Leuchte mit einer erfindungsgemäßen Anordnung, bei der das Halbleiterbauelement eine Halbleiterlichtquelle, insbesondere eine LED, ist oder eine solche umfasst.

Insbesondere kann die Leuchte als Kfz-Leuchte ausgebildet sein oder eine solche umfassen.

Bei heutigen Kfz-Leuchten, beispielsweise Abblendlicht-, Fernlicht- oder Tagfahrleuchten, kommen eine Vielzahl von Halbleiterlichtquellen, insbesondere Hochleistungs-LEDs, zum Einsatz. Aufgrund der hohen erzeugten Lichtleistungen und der damit verbundenen insgesamt hohen Verlustleistung bzw. Abwärmeproduktion unterliegen die Halbleiterlichtquellen von Kfz-Leuchten besonders hohen thermischen Belastungen. Diese können wie eingangs geschildert verkürzte Lebensdauern nach sich ziehen. Erfindungsgemäß wird daher eine schaltungstechnische besonders einfache Anordnung bereitgestellt, bei der im Bedarfsfall die betreffenden Halbleiterlichtquellen insbesondere sowohl mit gesteigerter Leistung aktiv gekühlt als auch gleichzeitig abgeregelt werden können. Die Lebensdauern der Halbleiterlichtquellen und damit auch der gesamten Kfz-Leuchte lassen sich verlängern.

In den Rahmen der Erfindung fällt des Weiteren ein Verfahren zum Betrieb wenigstens eines Halbleiterbauelements, insbesondere zum Betrieb einer Halbleiterlichtquelle, besonders bevorzugt zum Betrieb wenigstens einer LED, wobei das zu betreibende Halbleiterbauelement durch eine thermoelektrische Komponente temperiert, insbesondere gekühlt und/oder beheizt, wird, und wobei ein Versorgungsstrom zur Energieversorgung des Halbleiterbauelements in eine das Halbleiterbauelement und die thermoelektrische Komponente umfassende Anordnung eingespeist wird, wobei ein von einer Temperatur des Halbleiterbauelements abhängiger Anteil des in die Anordnung eingespeisten Versorgungsstroms am Halbleiterbauelement vorbei geleitet und in die thermoelektrische Komponente gespeist wird, sodass das Halbleiterbauelement mit einem mindestens um den temperaturabhängigen Anteil des Versorgungsstroms reduzierten, zweiten Anteil des eingespeisten Versorgungsstroms mit Energie versorgt wird.

Somit ist es nicht mehr erforderlich, den beispielsweise von einer externen Versorgungstromquelle erzeugten und in die Anordnung eingespeisten Versorgungsstrom in Abhängigkeit der Temperatur des Halbleiterbauelements zu regeln. Vielmehr kann das Halbleiterbauelement unabhängig vom eingespeisten Versorgungsstrom abgeregelt und temperiert werden.

Vorzugsweise kann der temperaturabhängige Anteil des in die Anordnung eingespeisten Versorgungsstroms ganz oder teilweise zur Steigerung der Temperierleistung der thermoelektrischen Komponente, insbesondere ihrer Kühl- und/oder Heizleistung, verwendet werden, so dass die Temperierung, insbesondere Kühlung, des Halbleiterbauelements noch leistungsstärker wird.

Bevorzugt kann als Anordnung eine der vorangehend beschriebenen erfindungsgemäßen Anordnungen verwendet werden.

Es kann vorgesehen sein, dass die Vorbeilenkung und Speisung des temperaturabhängigen Anteils des Versorgungsstroms in die thermoelektrische Komponente ab Erreichen und/oder Überschreiten einer ersten Temperaturschwelle erfolgt.

Weitere Merkmale und Vorteile der Erfindung ergeben sich aus der nachfolgenden detaillierten Beschreibung eines Ausführungsbeispiels der Erfindung anhand der Figuren der Zeichnung, die erfindungswesentliche Einzelheiten zeigen, sowie aus den Ansprüchen.

Die einzelnen Merkmale können je einzeln für sich oder zu mehreren in beliebigen Kombinationen bei Varianten der Erfindung verwirklicht sein. In der schematischen Zeichnung sind Ausführungsbeispiele der Erfindung dargestellt, welche in der nachfolgenden Beschreibung näher erläutert werden.

Es zeigen:
- Fig.1: eine schematische Darstellung einer Kfz-Leuchte mit einer Anordnung zum Betrieb eines Halbleiterbauelements;
- Fig. 2: eine Schaltskizze der Anordnung aus Fig. 1 und
- Fig. 3: ein schematisches Anteil-Temperatur-Diagramm.

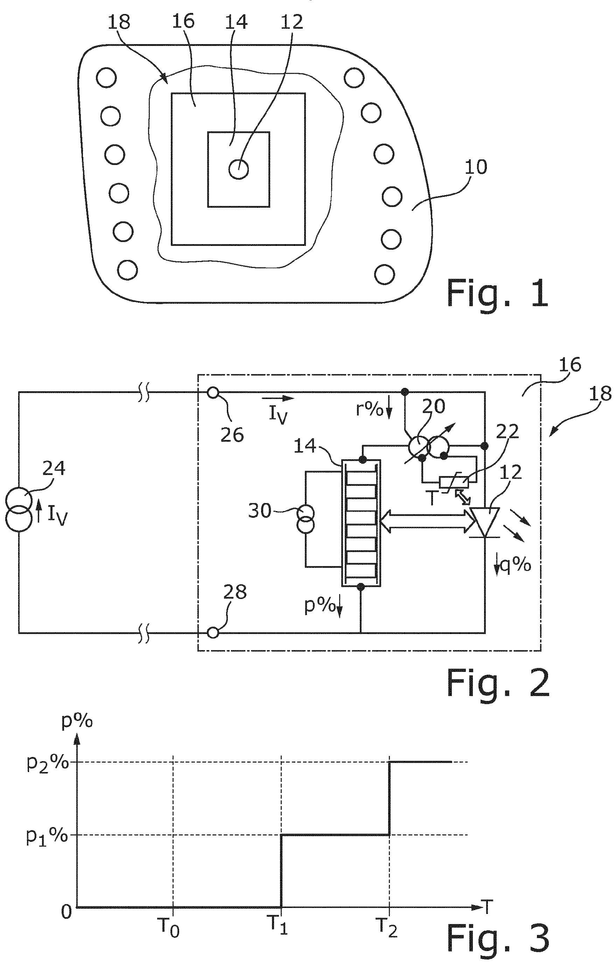

**Fig. 1** zeigt in schematischer Darstellung eine Kfz-Leuchte **10** von vorne mit Blick ins Innere der Kfz-Leuchte 10. Die Kfz-Leuchte 10 weist zur Lichterzeugung eine Vielzahl von Halbleiterlichtquellen auf, von denen eine Halbleiterlichtquelle **12** beispielhaft in Fig. 1 mit einem Bezugszeichen markiert ist.

Die Halbleiterlichtquelle 12 ist eine LED, insbesondere eine Hochleistungs-LED. Sie ist somit ein Halbleiterbauelement.

Eine thermoelektrische Komponente **14** ist thermisch mit der Halbleiterlichtquelle 12 gekoppelt. Insbesondere ist die Halbleiterlichtquelle 12 in einer Ausnehmung (in Fig. 1 nicht dargestellt) der thermoelektrischen Komponente 14 angeordnet, so dass ein besonders guter Wärmetransport zwischen den beiden Elementen 12 und 14 ermöglicht wird.

Die thermoelektrische Komponente 14 ist als Peltier-Element ausgebildet. Sie ist in ein als Leiterplatte ausgebildetes Bauelementesubstrat **16** integriert.

Die Halbleiterlichtquelle 12, die thermoelektrische Komponente 14 und das Bauelementesubstrat 16 sind Teil einer Anordnung **18.**

Anhand von **Fig. 2** sollen im Folgenden der Aufbau und die Funktionsweise der Anordnung 18 näher erläutert werden. Dazu zeigt Fig. 2 eine Schaltskizze der Anordnung 18.

Zu erkennen ist, dass die thermoelektrische Komponente 14 parallel zur Halbleiterlichtquelle 12 geschaltet ist. Die thermische Kopplung der thermoelektrischen Komponente 14 mit der Halbleiterlichtquelle 12 ist in Fig. 2 durch einen Doppelpfeil symbolisiert.

In diesem Ausführungsbeispiel ist die als Peltier-Element ausgebildete thermoelektrische Komponente 14 eingerichtet, die Halbleiterlichtquelle 12, insbesondere bei Bedarf, zu kühlen.

In Reihenschaltung zur thermoelektrischen Komponente 14 und insbesondere anodenseitig der als LED ausgebildeten Halbleiterlichtquelle 12 ist eine Steuereinheit **20** angeordnet. Die Steuereinheit 20 ist ebenfalls Teil der Anordnung 18.

Die Steuereinheit 20 ist als, insbesondere temperaturabhängig, regelbare Stromquelle ausgebildet. Sie ist dazu mit einem Temperatursensor **22,** insbesondere einem Heißleiter, elektrisch verbunden. Der Temperatursensor 22 wiederum steht in thermischer Verbindung mit der Halbleiterlichtquelle 12, was in Fig. 2 ebenfalls durch einen Doppelpfeil symbolisiert ist. Somit kann der Temperatursensor 22 die Temperatur **T** der Halbleiterlichtquelle 12 erfassen und die entsprechende Temperaturinformation der Steuereinheit 20 übermitteln.

Zur Energieversorgung der Halbleiterlichtquelle 12 mit einem Versorgungsstrom **Iᵥ** weist die Anordnung 18 zwei Versorgungsstromanschlüsse **26, 28** auf.

Der Versorgungsstrom I_{V} ist durch eine, nicht zur Anordnung 18 gehörende, externe Versorgungsstromquelle **24** erzeugbar. Denkbar ist, dass die externe Versorgungsstromquelle 24 den Versorgungsstrom I_{V} abhängig von dem durch die Kfz-Leuchte 10 (Fig. 1) zu erzeugenden bzw. gewünschten Lichtstrom regelt und insbesondere je nach Bedarf ein- und/oder ausschaltet. Der Versorgungsstrom I_{V} kann, beispielsweise zur Dimmung der Halbleiterlichtquelle 12, getaktet sein.

Die Steuereinheit 20 ist eingerichtet, bei in die Anordnung 18 über die Versorgungsstromanschlüsse 26, 28 eingespeistem Versorgungsstrom I_{V} einen von der Temperatur T abhängigen Anteil **p%** des eingespeisten Versorgungsstroms I_{V} an der Halbleiterlichtquelle 12 vorbei zu leiten und in die thermoelektrische Komponente 14 zu speisen.

Dazu ist die Steuereinheit 20 eingerichtet, die vom Temperatursensor 22 übermittelte Temperaturinformation über die Temperatur T der Halbleiterlichtquelle 12 auszuwerten, anhand dieser Temperaturinformation einen Wert für den temperaturabhängigen Anteil p% zu bestimmen und die durch die Steuereinheit 20 fließende Stromstärke dem jeweiligen temperaturabhängigen Anteil p% des Versorgungsstroms I_{V} entsprechend einzustellen und/oder zu regeln.

Somit wird die Halbleiterlichtquelle 12 durch einen mindestens um den temperaturabhängigen Anteil p% verringerten, zweiten Anteil **q%** des eingespeisten Versorgungsstroms I_{V} mit Energie versorgt. Mit anderen Worten wird die Halbleiterlichtquelle 12 mindestens entsprechend dem temperaturabhängigen Anteil p% des Versorgungsstroms I_{V} abgeregelt.

Der temperaturabhängige Anteil p% des Versorgungsstroms I_{V} wird in die thermoelektrische Komponente 14 zu deren Energieversorgung eingespeist. Dadurch erhöht sich die von der thermoelektrischen Komponente 14 erzeugte Kühlleistung.

Somit wird die von der Halbleiterlichtquelle 12 erzeugte Verlustleistung bzw. Abwärme reduziert. Gleichzeitig erfolgt eine leistungsgesteigerte Kühlung der Halbleiterlichtquelle 12 durch die thermoelektrische Komponente 14.

Die Energieversorgung der thermoelektrischen Komponente 14 erfolgt in diesem Ausführungsbeispiel sowohl durch eine Komponentenstromversorgung **30** als auch - wie vorangehend erläutert - durch den temperaturabhängigen Anteil p% des Versorgungsstroms I_{V}.

Vorzugsweise ist die Komponentenstromversorgung 30 ebenfalls temperaturgesteuert ausgebildet. Sie kann eingerichtet sein, die thermoelektrische Komponente 14 bei Erreichen und/oder Überschreiten einer Basis-Temperaturschwelle **T₀** mit einer, insbesondere vordefinierten, Basis-Kühlleistung zu betreiben. Bei Unterschreiten der Basis-Temperaturschwelle T₀ kann die Komponentenstromversorgung 30 eingerichtet sein, die Kühlleistung der thermoelektrischen Komponente 14 zu reduzieren oder die thermoelektrische Komponente 14 vollständig auszuschalten.

In diesem Ausführungsbeispiel erfolgt die Energieversorgung der Steuereinheit 20 durch einen weiteren Anteil **r%** des Versorgungsstroms I_{V}, der von diesem abgezweigt und in die Steuereinheit 20 eingespeist wird. Alternativ oder ergänzend ist auch denkbar, dass die Steuereinheit 20 durch eine separate Energieversorgungseinheit und/oder mittels des durch sie hindurchfließenden temperaturabhängigen Anteils p% des Versorgungsstroms I_{V} mit der für ihren Betrieb benötigten Energie versorgt wird.

Anhand von **Fig. 3** soll nun ein Ausführungsbeispiel des erfindungsgemäßen Verfahrens näher erläutert werden. Dazu zeigt Fig. 3 ein Anteil-Temperatur-Diagramm. Zum besseren Verständnis wird zur Bezeichnung von Elementen auf die Bezugszeichen der Fig. 2 Bezug genommen.

Zu erkennen ist, dass bis zu einer ersten Temperaturschwelle **T₁** der temperaturabhängige Anteil p% des Versorgungsstroms I_{V} 0% oder zumindest im Wesentlichen 0% beträgt. Überschreitet die Temperatur T der Halbleiterlichtquelle 12 die erste Temperaturschwelle T₁, so steigt der temperaturabhängige Anteil p% des Versorgungsstroms I_{V} auf **p₁%.** Somit wird ab Erreichen und/oder Überschreiten der ersten Temperaturschwelle T₁ die Kühlleistung der thermoelektrischen Komponente 14 erhöht und die Halbleiterlichtquelle 12 zumindest teilweise abgeregelt.

Erhöht sich die Temperatur T der Halbleiterlichtquelle 12 weiter, insbesondere bis zu oder über eine zweite Temperaturschwelle T₂, so wird ein, insbesondere weiter erhöhter, Anteil **p₂%** des Versorgungstroms I_{V} abgezweigt und die Halbleiterlichtquelle 12 weiter, insbesondere noch stärker, abgeregelt. P₂% kann 100 % entsprechen oder zumindest im Wesentlichen im Bereich von 100 % liegen. Mit anderen Worten kann die Steuereinheit 20 (Fig. 2), insbesondere für diesen Fall, dass die Temperatur T die zweite Temperaturschwelle T₂ erreicht oder überschreitet, eingerichtet sein, die Halbleiterlichtquelle 12 vollständig oder zumindest im Wesentlichen vollständig abzuregeln, insbesondere auszuschalten.

Alternativ oder ergänzend ist denkbar, dass anstelle eines derart, insbesondere zweifach, gestuften Anteil-Temperatur-Verlaufs auch andere, beispielsweise gestufte, stetige, insbesondere lineare, Anteil-Temperatur-Verläufe vorgesehen sind. Günstig ist es, wenn ein solcher Anteil-Temperatur-Verlauf vorgesehen ist, bei dem zumindest mit steigender Temperatur der Anteil p%, vorzugsweise stetig, steigt, so dass letzten Endes mit steigender Temperatur T die Kühlleistung der thermoelektrischen Komponente 14 zumindest oberhalb einer ersten Temperaturschwelle **T₁** höher ist als unterhalb dieser ersten Temperaturschwelle T₁.

Erfindungsgemäß ist somit vorgesehen, die Halbleiterlichtquelle 12 zu betreiben, wobei sie durch die thermoelektrische Komponente 14 temperiert wird. Insbesondere wird sie bei Bedarf, hier insbesondere bei Überschreiten der Temperaturschwelle T₀, gekühlt. Dabei wird zur Energieversorgung der Halbleiterlichtquelle 12 der Versorgungsstrom I_{V} in die Anordnung 18 eingespeist. In Abhängigkeit der Temperatur T der Halbleiterlichtquelle 12 - in diesem Falle gemessen mithilfe des Temperatursensors 22 - wird der temperaturabhängige Anteil p% an der Halbleiterlichtquelle 12 vorbei gelenkt und in die thermoelektrische Komponente 14 gespeist. Dazu wird der temperaturabhängige Anteil p% durch die Steuereinheit 20 je nach Temperatur T der Halbleiterlichtquelle 12 zu 0% bzw. im Wesentlichen 0%, p₁% oder p₂% bestimmt.

Somit wird die Halbleiterlichtquelle 12 nur noch von einem mindestens um den temperaturabhängigen Anteil p% des eingespeisten Versorgungsstroms I_{V} reduzierten, zweiten Anteil q% des eingespeisten Versorgungsstroms I_{V} mit Energie versorgt. Gleichzeitig kann die Kühlleistung der thermoelektrischen Komponente 14, insbesondere zur zusätzlichen Temperierung bzw. Kühlung der Halbleiterlichtquelle 12, gesteigert werden.

In den beschriebenen Ausführungsbeispielen ist das zu temperierende Halbleiterbauelement lediglich beispielhaft die Halbleiterlichtquelle 12, also eine LED.

Anstelle der oder ergänzend zur Halbleiterlichtquelle 12 können auch weitere und/oder andere Halbleiterbauelemente Teil der erfindungsgemäßen Anordnung 18 sein und/oder im Rahmen des erfindungsgemäßen Verfahrens vorgesehen werden. Dies betrifft beispielsweise ein oder mehrere Leistungshalbleiter, beispielsweise Halbleiterdioden, Halbleiterschalter und/oder Halbleiterverstärker, insbesondere, wenn hohe Wärmeverluste auftreten und/oder zu erwarten sind. Diese Halbleiterbauelemente können Teil wenigstens eines Steuergerätes sein und/oder von wenigstens einem solchen gesteuert und insbesondere mit Energie versorgt sein bzw. werden.

### Bezugszeichenliste

- 10: Leuchte
- 12: Halbleiterlichtquelle
- 14: Komponente
- 16: Bauelementesubstrat
- 18: Anordnung
- 20: Steuereinheit
- 22: Temperatursensor
- 24: externe Versorgungsstromquelle
- 26: Versorgungsstromanschluss
- 28: Versorgungsstromanschluss
- 30: Komponentenstromversorgung
- Iv: Versorgungsstrom
- T: Temperatur
- T₀: Basis-Temperaturschwelle
- T₁: erste Temperaturschwelle
- T₂: zweite Temperaturschwelle
- p%: temperaturabhängiger Anteil
- p₀%: Anteil
- p₁%: Anteil
- p₂%: Anteil
- q%: zweiter Anteil
- r%: weiterer Anteil

## Patentansprüche

1. **Anordnung** (18) zum Betrieb wenigstens eines Halbleiterbauelements, umfassend
- wenigstens ein zu betreibendes Halbleiterbauelement und
- wenigstens eine thermoelektrische Komponente (14),
wobei die thermoelektrische Komponente (14) eingerichtet ist, das Halbleiterbauelement zu temperieren, insbesondere zu kühlen und/oder zu beheizen,
wobei die Anordnung (18) wenigstens einen Versorgungsstromanschluss (26, 28) zur Energieversorgung des Halbleiterbauelements mit einem Versorgungsstrom (I_{V}) aufweist,
wobei die Anordnung (18) eine Steuereinheit (20) und einen mit der Steuereinheit (20) verbundenen Temperatursensor (22), der zur Erfassung einer Temperatur (T) des Halbleiterbauelements eingerichtet ist, aufweist, **dadurch gekennzeichnet, dass** die Steuereinheit (20) eingerichtet ist, einen von der Temperatur (T) abhängigen Anteil (p%) des am Versorgungsstromanschluss (26, 28) in die Anordnung (18) eingespeisten Versorgungsstroms (I_{V}) am Halbleiterbauelement vorbei zu leiten und in die thermoelektrische Komponente (14) zu speisen.

2. Anordnung nach Anspruch 1, **dadurch gekennzeichnet, dass** die Steuereinheit (20) als steuerbare, insbesondere temperaturabhängig steuerbare, Stromquelle ausgebildet ist oder eine solche umfasst.

3. Anordnung nach einem der vorhergehenden Ansprüche, **dadurch gekennzeichnet, dass** die thermoelektrische Komponente (14) ein Peltier-Element ist oder ein solches umfasst.

4. Anordnung nach einem der vorhergehenden Ansprüche, **dadurch gekennzeichnet, dass** die Anordnung (18) ein Bauelementesubstrat (16), insbesondere eine Leiterplatte, umfasst, wobei die thermoelektrische Komponente (14) in das Bauelementesubstrat (16) integriert ist.

5. Anordnung nach einem der vorhergehenden Ansprüche, **dadurch gekennzeichnet, dass** die thermoelektrische Komponente (14) mit dem Halbleiterbauelement thermisch, vorzugsweise unmittelbar, gekoppelt ist.

6. Anordnung nach einem der vorhergehenden Ansprüche, **dadurch gekennzeichnet, dass** die Anordnung (18) eingerichtet ist, die Steuereinheit (20) durch einen weiteren Anteil (r%) des eingespeisten Versorgungsstroms (Iv) mit Energie zu versorgen.

7. Anordnung nach einem der vorhergehenden Ansprüche, **dadurch gekennzeichnet, dass** das Halbleiterbauelement eine Halbleiterlichtquelle (12), insbesondere eine LED, ist oder eine solche umfasst.

8. **Leuchte** (10) mit einer Anordnung (18) nach dem vorhergehenden Anspruch.

9. Leuchte nach dem vorhergehenden Anspruch, **dadurch gekennzeichnet, dass** die Leuchte (10) als KFZ-Leuchte ausgebildet ist oder eine solche umfasst.

10. **Verfahren** zum Betrieb wenigstens eines Halbleiterbauelements, insbesondere zum Betrieb einer Halbleiterlichtquelle (12), besonders bevorzugt zum Betrieb wenigstens einer LED, wobei das zu betreibende Halbleiterbauelement durch eine thermoelektrische Komponente (14) temperiert, insbesondere gekühlt und/oder beheizt, wird, und wobei ein Versorgungsstrom (I_{V}) zur Energieversorgung des Halbleiterbauelements in eine das Halbleiterbauelement und die thermoelektrische Komponente (14) umfassende Anordnung (18) eingespeist wird,
**dadurch gekennzeichnet,**
**dass** ein von einer Temperatur (T) des Halbleiterbauelements abhängiger Anteil (p%) des in die Anordnung (18) eingespeisten Versorgungsstroms (I_{V}) am Halbleiterbauelement vorbei geleitet und in die thermoelektrische Komponente (14) gespeist wird, sodass das Halbleiterbauelement mit einem mindestens um den temperaturabhängigen Anteil (p%) des Versorgungsstroms (I_{V}) reduzierten, zweiten Anteil (q%) des eingespeisten Versorgungsstroms (I_{V}) mit Energie versorgt wird.

11. Verfahren nach dem vorhergehenden Anspruch, **dadurch gekennzeichnet, dass** der temperaturabhängige Anteil (p%) des in die Anordnung (18) eingespeisten Versorgungsstroms (I_{V}) ganz oder teilweise zur Steigerung der Temperierleistung der thermoelektrischen Komponente (14), insbesondere ihrer Kühl- und/oder Heizleistung, verwendet wird.

12. Verfahren nach einem der Ansprüche 10 oder 11, **dadurch gekennzeichnet, dass** als Anordnung (18) eine Anordnung (18) nach einem der Ansprüche 1 bis 7 verwendet wird.

13. Verfahren nach einem der Ansprüche 10 bis 12, **dadurch gekennzeichnet, dass** die Vorbeilenkung und Speisung des temperaturabhängigen Anteils (p%) des Versorgungsstroms (I_{V}) in die thermoelektrische Komponente (14) ab Erreichen und/oder Überschreiten einer ersten Temperaturschwelle (T₁) erfolgt.

## Claims

1. **Assembly** (18) for operating at least one semiconductor component, comprising
- at least one semiconductor component to be operated and
- at least one thermoelectric component (14),
the thermoelectric component (14) being configured to control the temperature of the semiconductor component, in particular to cool and/or heat the semiconductor component,
the assembly (18) having at least one supply current connection (26, 28) for supplying energy to the semiconductor component by means of a supply current (I_{V}),
the assembly (18) having a control unit (20) and a temperature sensor (22) which is connected to the control unit (20) and is configured to detect a temperature (T) of the semiconductor component, **characterized in that**
the control unit (20) is configured to conduct a portion (p%), which is dependent on the temperature (T), of the supply current (I_{V}), which is fed into the assembly (18) at the supply current connection (26, 28), past the semiconductor component and to feed said portion into the thermoelectric component (14).

2. Assembly according to claim 1, **characterized in that** the control unit (20) is designed as a controllable current source, in particular a current source which can be controlled depending on the temperature, or comprises such a current source.

3. Assembly according to either of the preceding claims, **characterized in that** the thermoelectric component (14) is a Peltier element or comprises such an element.

4. Assembly according to any of the preceding claims, **characterized in that** the assembly (18) comprises a component substrate (16), in particular a printed circuit board, the thermoelectric component (14) being integrated into the component substrate (16).

5. Assembly according to any of the preceding claims, **characterized in that** the thermoelectric component (14) is thermally, preferably directly, coupled to the semiconductor component.

6. Assembly according to any of the preceding claims, **characterized in that** the assembly (18) is configured to supply the control unit (20) with energy by means of a further portion (r%) of the fed supply current (I_{V}).

7. Assembly according to any of the preceding claims, **characterized in that** the semiconductor component is a semiconductor light source (12), in particular an LED, or comprises such a semiconductor light source.

8. **Light** (10) comprising an assembly (18) according to the preceding claim.

9. Light according to the preceding claim, **characterized in that** the light (10) is designed as a motor vehicle light or comprises such a motor vehicle light.

10. **Method** for operating at least one semiconductor component, in particular for operating a semiconductor light source (12), particularly preferably for operating at least one LED, the temperature of the semiconductor component to be operated being controlled, in particular cooled and/or heated, by a thermoelectric component (14), and a supply current (I_{V}) for supplying energy to the semiconductor component being fed into an assembly (18) that comprises the semiconductor component and the thermoelectric component (14),
**characterized in that**
a portion (p%), which is dependent on the temperature (T) of the semiconductor component, of the supply current (I_{V}), which is fed into the assembly (18), is conducted past the semiconductor component and fed into the thermoelectric component (14), such that the semiconductor component is supplied with energy by means of at least one second portion (q%) of the fed supply current (I_{V}) which is reduced by the temperature-dependent portion (p%) of the supply current (I_{V}).

11. Method according to the preceding claim, **characterized in that** the temperature-dependent portion (p%) of the supply current (I_{V}) fed into the assembly (18) is wholly or partially used to increase the temperature control performance of the thermoelectric component (14), in particular the cooling and/or heating performance thereof.

12. Method according to either claim 10 or claim 11, **characterized in that** an assembly (18) according to any of claims 1 to 7 is used as the assembly (18).

13. Method according to any of claims 10 to 12, **characterized in that** the temperature-dependent portion (p%) of the supply current (I_{V}) is diverted and fed into the thermoelectric component (14) after reaching and/or exceeding a first temperature threshold (T₁).

## Revendications

1. **Agencement** (18) permettant de faire fonctionner au moins un dispositif semi-conducteur, comprenant
- au moins un dispositif semi-conducteur à faire fonctionner et
- au moins un composant thermoélectrique (14), le composant thermoélectrique (14) étant configuré pour réguler la température du dispositif semi-conducteur, en particulier pour le refroidir et/ou le chauffer,
l'agencement (18) présentant au moins une
connexion de courant d'alimentation (26, 28) permettant d'alimenter en énergie le dispositif semi-conducteur avec un courant d'alimentation (I_{V}),
l'agencement (18) présentant une unité de commande (20) et un capteur de température (22) connecté à l'unité de commande (20) et étant configuré pour détecter une température (T) du dispositif semi-conducteur, **caractérisé en ce que**
l'unité de commande (20) est configurée pour conduire une proportion (p%), dépendante de la température (T), du courant d'alimentation (I_{V}) introduit dans l'agencement (18) par l'intermédiaire de la connexion de courant d'alimentation (26, 28) au-delà du dispositif semi-conducteur et l'introduire dans le composant thermoélectrique (14).

2. Agencement selon la revendication 1, **caractérisé en ce que** l'unité de commande (20) est conçue comme une source de courant commandable, en particulier commandable en fonction de la température, ou en comprend une.

3. Agencement selon l'une des revendications précédentes, **caractérisé en ce que** le composant thermoélectrique (14) est ou comprend un élément Peltier.

4. Agencement selon l'une des revendications précédentes, **caractérisé en ce que** l'agencement (18) comprend un substrat de dispositif (16), en particulier une carte de circuit imprimé, le composant thermoélectrique (14) étant intégré dans le substrat de dispositif (16).

5. Agencement selon l'une des revendications précédentes, **caractérisé en ce que** le composant thermoélectrique (14) est thermiquement, de préférence directement, couplé au dispositif semi-conducteur.

6. Agencement selon l'une des revendications précédentes, **caractérisé en ce que** l'agencement (18) est configuré pour alimenter en énergie l'unité de commande (20) par une autre proportion (r%) du courant d'alimentation (I_{V}) introduit.

7. Agencement selon l'une des revendications précédentes, **caractérisé en ce que** le dispositif semi-conducteur est ou comprend une source lumineuse à semi-conducteur (12), en particulier une DEL.

8. **Luminaire** (10) comportant un agencement (18) selon la revendication précédente.

9. Luminaire selon la revendication précédente, **caractérisé en ce que** le luminaire (10) est conçu sous forme de luminaire de véhicule automobile, ou en comprend un.

10. **Procédé** permettant de faire fonctionner au moins un dispositif semi-conducteur, en particulier pour faire fonctionner une source lumineuse à semi-conducteur (12), de manière particulièrement préférée pour faire fonctionner au moins une DEL, le dispositif semi-conducteur à faire fonctionner étant tempéré, en particulier refroidi et/ou chauffé, par un composant thermoélectrique (14), et un courant d'alimentation (I_{V}) permettant d'alimenter en énergie le dispositif semi-conducteur étant introduit dans un agencement (18) comprenant le dispositif semi-conducteur et le composant thermoélectrique (14),
**caractérisé en ce**
**qu'**une proportion (p%), dépendante de la température (T) du dispositif semi-conducteur, du courant d'alimentation (I_{V}) introduit dans l'agencement (18) est conduite au-delà du dispositif semi-conducteur et introduite dans le composant thermoélectrique (14), de sorte que le dispositif semi-conducteur est alimenté en énergie par une seconde proportion (q%) du courant d'alimentation (I_{V}) introduit, laquelle est réduite par au moins la proportion (p%), dépendante de la température, du courant d'alimentation (I_{V}).

11. Procédé selon la revendication précédente, **caractérisé en ce que** la proportion (p%), dépendante de la température, du courant d'alimentation (I_{V}) introduit dans l'agencement (18) est entièrement ou partiellement utilisée pour augmenter les capacités de régulation de température du composant thermoélectrique (14), en particulier sa capacité de refroidissement et/ou de chauffage.

12. Procédé selon l'une des revendications 10 ou 11, **caractérisé en ce qu'**un agencement (18) selon l'une des revendications 1 à 7 est utilisé comme agencement (18).

13. Procédé selon l'une des revendications 10 à 12, **caractérisé en ce que** le passage et l'introduction de la proportion (p%), dépendante de la température, du courant d'alimentation (I_{V}) dans le composant thermoélectrique (14) s'effectue après avoir atteint et/ou dépassé un premier seuil de température (T₁).
